# FASCICULE DE BREVET EUROPEEN

(11) **EP 2 883 267 B1**
(45) Date de publication et mention de la délivrance du brevet: **07.09.2016**
(21) Numéro de dépôt: 13758945.3
(22) Date de dépôt: 06.08.2013
(51) Int. Cl.: H01M 10/42, H01M 10/48, H01M 10/617, H01M 6/42, H01M 10/633, G01R 31/36, H01M 10/052, H01M 6/44, H01M 2/10

(54) **PROCÉDÉ DE RÉALISATION D'UNE BATTERIE ÉLECTRIQUE**
VERFAHREN ZUR HERSTELLUNG EINER ELEKTROBATTERIE
METHOD OF PRODUCING AN ELECTRIC BATTERY

(30) Priorité: 08.08.2012 FR 1257690
(43) Date de publication de la demande: 17.06.2015
(73) Titulaire: Commissariat à l'Energie Atomique et aux Energies Alternatives, 75015 Paris (FR)
(72) Inventeur: KAROUI, Fathia, 73000 Chambery (FR); LEMAIRE, Elisabeth, 38490 Les Abrets (FR); MARTIN, Nicolas, 73200 Albertville (FR)
(74) Mandataire: Thibon, Laurent
(86) Numéro de dépôt international: PCT/FR2013/051898
(87) Numéro de publication internationale: WO 2014/023914

(56) Documents cités:
- GB-A- 2 136 629
- JP-A- 2004 303 456
- JP-A- 2008 084 691
- JP-A- 2009 152 208
- US-A1- 2010 047 684
- US-A1- 2011 213 509
- Radu Gogoana: "Internal resistance variances in lithium-ion batteries and implications in manufacturing", Thesis (S.M.)--Massachusetts Institute of Technology, Dept. of Mechanical Engineering, 2012. , 28 juin 2012 (2012-06-28), XP055057927, Extrait de l'Internet: URL:http://hdl.handle.net/1721.1/74917 [extrait le 2013-03-27]

## Description

### Domaine de l'invention

La présente invention concerne de façon générale les batteries électriques, et vise plus particulièrement un procédé de réalisation d'une batterie.

### Exposé de l'art antérieur

Dans certaines batteries, certaines cellules peuvent, en fonctionnement, subir un échauffement important, ce qui pose des problèmes de vieillissement prématuré pouvant entraîner une perte de capacité de la batterie et une diminution de sa durée de vie. De plus, ceci engendre un besoin d'équilibrage important.

La demande de brevet JP2004303456 décrit une solution qui a été proposée pour essayer d'augmenter la durée de vie d'une batterie. Dans ce document, il est prévu de placer aux emplacements de la batterie évacuant le moins bien la chaleur des cellules ayant une résistance interne plus faible d'au moins 15 % que les autres cellules.

La demande de brevet JP2008084691 décrit une solution qui a été proposée pour essayer de réduire les dégradations liées à la répétition des cycles de charge/décharge dans une batterie. Dans ce document, les cellules sont identiques aux dispersions de fabrication près. Il est prévu de mesurer la résistance interne de chaque cellule avant l'assemblage, puis de réaliser l'assemblage en disposant les cellules de façon que chaque cellule soit entourée de deux cellules de plus forte ou de plus faible résistance interne (c'est-à-dire en alternant les cellules à faible/forte résistance interne).

Le mémoire intitulé "Internal résistance variances in lithium-ion batteries and implications in manufacturing" de Radu Gogoana (http://hdl.handle.net/1721.1/74917) enseigne que les cellules élémentaires d'une batterie sont sujettes à des dispersions de fabrication pouvant se traduire par des différences de résistance interne impactant la répartition des courants dans la batterie.

### Résumé

Un objet d'un mode de réalisation de la présente invention est de réaliser une batterie palliant tout ou partie des inconvénients des batteries existantes.

Un objet d'un mode de réalisation de la présente invention est de réaliser une batterie dans laquelle l'échauffement des cellules élémentaires est plus faible que dans les batteries existantes.

Un autre objet d'un mode de réalisation de la présente invention est de réaliser une batterie dont la durée de vie est améliorée par rapport aux batteries existantes.

Ainsi, un mode de réalisation de la présente invention prévoit un procédé de réalisation d'une batterie, dans lequel plusieurs cellules sont agencées en tenant compte de leurs résistances internes respectives.

Selon ce procédé, un emplacement dans la batterie est affecté à chaque cellule, en tenant compte des aptitudes respectives des emplacements à évacuer la chaleur.

Ce procédé comporte une étape de mesure de la résistance interne de chaque cellule.

Selon un mode de réalisation de ce procédé, les emplacements présentant les aptitudes à évacuer la chaleur les plus élevées sont affectés aux cellules les plus résistives et inversement.

Selon un mode de réalisation de ce procédé, les emplacements présentant les aptitudes à évacuer la chaleur les plus élevées sont affectés aux cellules dissipant la plus grande quantité d'énergie par effet Joule et inversement.

Selon un mode de réalisation de la présente invention, l'agencement tient compte du schéma de connexion électrique des cellules de la batterie.

Selon un mode de réalisation de la présente invention, les cellules élémentaires sont identiques à la dispersion de fabrication près.

### Brève description des dessins

Ces objets, caractéristiques et avantages, ainsi que d'autres seront exposés en détail dans la description suivante de modes de réalisation particuliers faite à titre non limitatif en relation avec les figures jointes parmi lesquelles :
la figure 1 est une vue en perspective représentant schématiquement un exemple de réalisation d'une batterie électrique ;
la figure 2 est un schéma bloc illustrant des étapes d'un mode de réalisation d'un procédé de fabrication d'une batterie électrique ;
la figure 3 est un schéma bloc illustrant des étapes d'un autre mode de réalisation d'un procédé de fabrication d'une batterie électrique ; et
la figure 4 est un schéma bloc illustrant des étapes d'une variante de réalisation d'un procédé de fabrication d'une batterie électrique.

### Description détaillée

Une batterie électrique est un groupement de plusieurs cellules élémentaires (piles, accumulateurs, etc.) reliées en série et/ou en parallèle entre deux noeuds ou bornes de fourniture d'une tension continue.

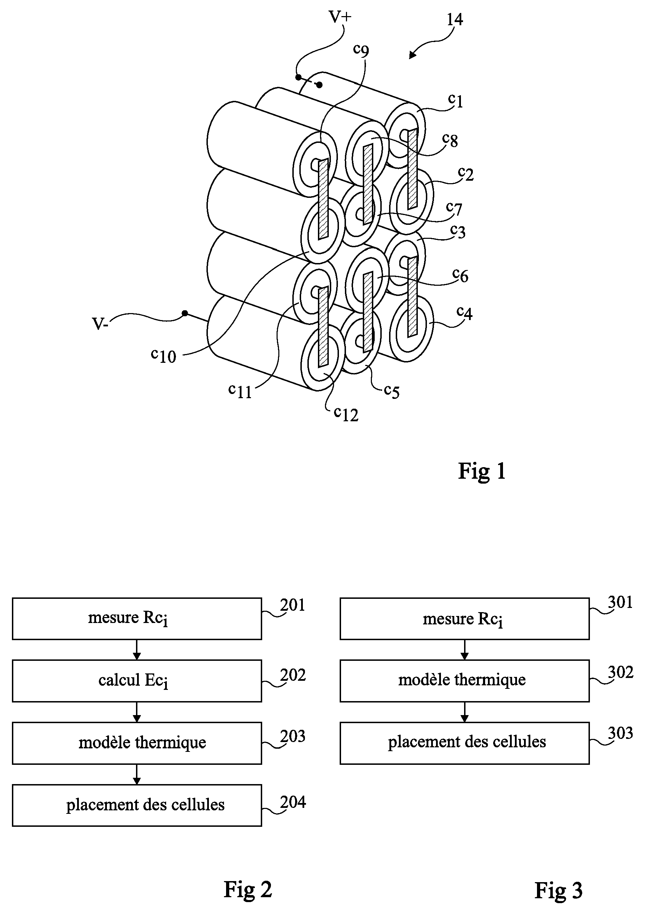

La figure 1 est une vue en perspective représentant schématiquement un exemple de réalisation d'une batterie 14 comportant douze cellules élémentaires cᵢ, i étant un entier allant de 1 à 12, connectées en série entre des bornes V+ et V-de fourniture d'une tension continue. Les cellules de la batterie sont généralement logées dans un boîtier de protection (non représenté) ne laissant accessible que deux cosses respectivement connectées aux bornes V+ et V- de la batterie.

Les emplacements d'accueil des cellules dans la batterie, et leurs positionnements relatifs, les uns par rapport aux autres, sont définis en fonction des contraintes du système utilisant la batterie, de la forme du packaging, du nombre de cellules à placer dans la batterie, etc.

En l'absence d'un système de refroidissement spécifique, les emplacements des cellules au sein d'une batterie n'ont généralement pas tous la même aptitude à évacuer la chaleur (ou capacité de refroidissement). A titre d'exemple, dans la batterie 14 de la figure 1, la chaleur produite par les cellules périphériques c₁ à c₅ et c₈ à c₁₂, présentant une surface d'échange relativement importante avec l'extérieur, est évacuée plus facilement que la chaleur produite par les cellules centrales c₆ et c₇, plus confinées. Il en résulte que certaines cellules chauffent plus que d'autres, et vieillissent donc plus rapidement.

Le vieillissement prématuré de certaines cellules de la batterie sous l'effet de la chaleur impacte de façon significative les performances de l'ensemble de la batterie, même si ces cellules sont peu nombreuses par rapport au nombre total de cellules de la batterie. En effet, le vieillissement d'une cellule élémentaire se traduit par une diminution de sa capacité et/ou une augmentation de sa résistance. Or, les batteries sont généralement munies de systèmes de gestion configurés de façon à interrompre la charge ou la décharge de la batterie dès que la charge ou la décharge des cellules élémentaires de plus faible capacité est terminée. Les performances de la batterie sont donc alignées sur celles de ses cellules élémentaires de plus faible capacité.

Pour limiter l'échauffement des cellules, on pourrait prévoir des batteries dans lesquelles les cellules sont espacées les unes des autres, et un fluide de refroidissement circule dans les espaces libres entre les cellules. On pourrait également prévoir des batteries dans lesquelles des pièces métalliques sont disposées entre les cellules pour faciliter l'évacuation de la chaleur. De tels systèmes sont toutefois coûteux et augmentent le poids et l'encombrement de la batterie.

Indépendamment des différences de comportement thermique entre les différents emplacements, dans la pratique, les cellules élémentaires d'une batterie, bien que théoriquement identiques, sont sujettes à des dispersions de fabrication. Les inventeurs ont notamment constaté que les cellules élémentaires d'une batterie n'ont pas toutes exactement la même résistance interne, y compris à l'état neuf. Il en résulte que, en fonctionnement, sous l'effet des courants circulant dans la batterie, certaines cellules chauffent plus que d'autres, et vieillissent donc plus rapidement.

Selon un aspect, on prévoit, avant l'assemblage de la batterie, de mesurer la résistance interne de chacune des cellules, et de choisir l'emplacement de chaque cellule dans le volume dans lequel s'inscrivent l'ensemble des cellules de la batterie réalisée, en tenant compte de sa résistance interne et du comportement thermique des emplacements, de façon à optimiser les performances de la batterie. Les résistances internes des différentes cellules sont de préférence mesurées dans des conditions identiques. A titre d'exemple, les mesures sont effectuées à pleine charge des cellules, à courant interne sensiblement nul, et à une température de l'ordre de 25°C. Les modes de réalisation décrits ne se limitent bien entendu pas à ce cas particulier.

La figure 2 est un schéma bloc illustrant des étapes d'un exemple d'un mode de réalisation d'un procédé de fabrication d'une batterie électrique.

Lors d'une étape 201 (mesure Rcᵢ), la résistance interne Rcᵢ de chacune des cellules élémentaires de la batterie est mesurée.

Lors d'une étape 202 (calcul Ecᵢ), en tenant compte de l'architecture (ou schéma électrique) de la batterie, et notamment de la distribution des courants dans la batterie en fonctionnement, ainsi que des résistances internes Rcᵢ mesurées à l'étape 201, les cellules élémentaires sont classées en fonction de la quantité d'énergie Ecᵢ qu'elles sont susceptibles de dissiper par effet Joule au cours du fonctionnement de la batterie.

A titre d'exemple, lorsque les cellules élémentaires sont reliées en série, elles sont toutes, traversées par un même courant I, égal au courant total circulant entre les bornes V+ et V- de la batterie. La quantité d'énergie dissipée (ou quantité de chaleur générée) par chaque cellule élémentaire est proportionnelle au produit de sa résistance interne Rcᵢ par le carré du courant I qui la traverse. Les cellules dont les résistances internes Rcᵢ sont les plus élevées sont donc celles qui génèrent le plus de chaleur, et inversement.

Lorsque les cellules élémentaires sont reliées en parallèle, le courant I traversant la batterie se divise en autant de courants élémentaires Icᵢ que la batterie comporte de cellules. Dans chaque cellule élémentaire, le courant Icᵢ est d'autant plus élevé que la résistance interne Rcᵢ de la cellule est faible, et inversement. La somme des courants Icᵢ est égale au courant total I circulant entre les bornes V+ et V- de la batterie. La quantité de chaleur générée par une cellule est proportionnelle au produit de sa résistance interne Rcᵢ par le carré du courant Icᵢ qui la traverse. Les inventeurs ont constaté qu'en pratique, à l'échelle des dispersions de fabrication, l'énergie dissipée dans les cellules peu résistives était plus importante que l'énergie dissipée dans les cellules fortement résistives. Les cellules dont les résistances internes sont les plus faibles (courants Icᵢ élevés) sont donc celles qui génèrent le plus de chaleur, et inversement.

Lors d'une étape 203 (modèle thermique), un modèle thermique de la batterie est déterminé. Lors de cette étape, pour chaque emplacement, un ou plusieurs paramètres représentatifs de l'aptitude de l'emplacement à évacuer la chaleur, ou capacité de refroidissement de l'emplacement, peuvent être déterminés. Les emplacements de cellule de la batterie sont classés en fonction de leur aptitude à évacuer la chaleur, ou capacité de refroidissement. A titre d'exemple, on peut affecter arbitrairement à chaque emplacement une capacité de refroidissement inversement proportionnelle à la distance qui le sépare du boîtier de protection de la batterie. Alternativement, un modèle thermique plus élaboré peut être déterminé par calcul et simulation des échanges de chaleur à l'intérieur de la batterie au cours de son fonctionnement.

Lors d'une étape 204 (placement des cellules), un emplacement est affecté à chaque cellule élémentaire, en tenant compte de la quantité de chaleur générée par la cellule en fonctionnement (liée à sa résistance interne) et de la capacité de refroidissement de l'emplacement, de façon à minimiser les écarts de température à l'intérieur de la batterie pendant son fonctionnement. En d'autres termes, les emplacements disposant d'une grande aptitude à évacuer la chaleur sont affectés à des cellules générant une grande quantité de chaleur, et inversement.

A titre d'exemple de procédé simple d'affectation des emplacements aux cellules, si un classement des cellules par ordre croissant de quantité de chaleur générée est réalisé à l'étape 202, et si un classement des emplacements par ordre croissant de capacité de refroidissement est réalisé à l'étape 203, le premier emplacement du classement d'emplacements est affecté à la première cellule du classement de cellules, le deuxième emplacement du classement d'emplacements est affecté à la deuxième cellule du classement de cellules, et ainsi de suite. On notera toutefois que dans cet exemple, le procédé d'affectation des emplacements aux cellules ne tient pas compte du fait que la quantité de chaleur générée par une cellule dépend en fait de la température de cette cellule, qui dépend elle-même de l'emplacement de la cellule. En effet, la résistance interne d'une cellule est généralement d'autant plus élevée que la température de la cellule est faible.

A titre de variante, des procédés plus perfectionnés d'affectation des emplacements aux cellules peuvent être prévus. Le procédé d'affectation peut par exemple comprendre un ou plusieurs algorithmes d'optimisation dans lesquels un critère ou paramètre choisi est maximisé ou minimisé. Les algorithmes d'optimisation peuvent avoir plusieurs itérations.

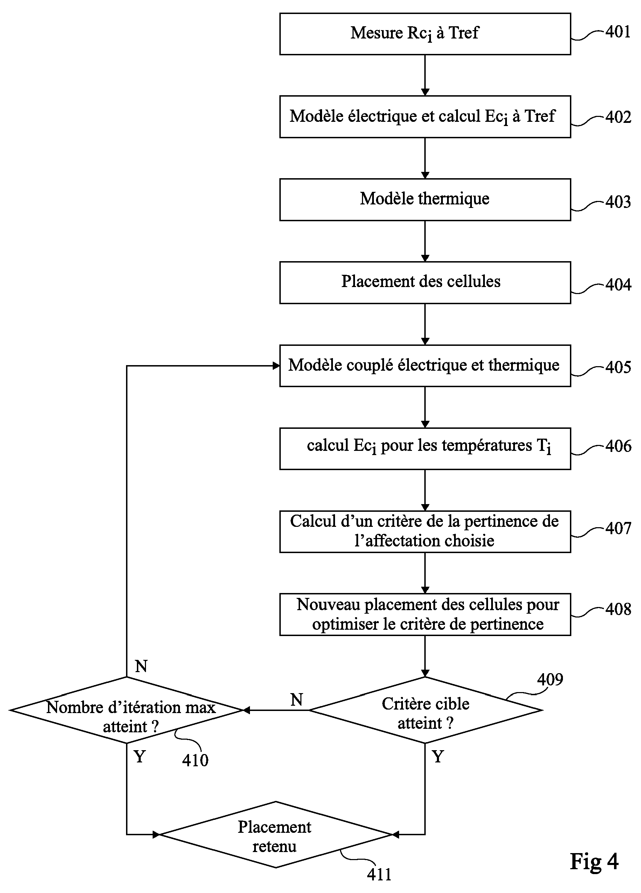

La figure 4 est un schéma bloc illustrant un exemple de réalisation d'un tel procédé perfectionné d'affectation des emplacements aux cellules.

Lors d'une étape 401 (mesure Rcᵢ à Tref), la résistance interne Rcᵢ de chacune des cellules élémentaires de la batterie est mesurée à une température de référence Tref identique pour toutes les cellules de la batterie.

Lors d'une étape 402 (modèle électrique et calcul Ecᵢ à Tref), en tenant compte de l'architecture (ou schéma électrique) de la batterie, et notamment de la distribution des courants dans la batterie en fonctionnement, ainsi que des résistances internes Rcᵢ mesurées à l'étape 401, les cellules élémentaires sont classées en fonction de la quantité d'énergie Ecᵢ qu'elles sont susceptibles de dissiper par effet Joule au cours du fonctionnement de la batterie à la température Tref.

Lors d'une étape 403 (modèle thermique), un modèle thermique de la batterie est déterminé. Lors de cette étape, pour chaque emplacement, un ou plusieurs paramètres représentatifs de l'aptitude de l'emplacement à évacuer la chaleur, ou capacité de refroidissement de l'emplacement, peuvent être déterminés. Les emplacements de cellule de la batterie peuvent être classés en fonction de leur aptitude à évacuer la chaleur, ou capacité de refroidissement.

Lors d'une étape 404 (placement des cellules), un emplacement est affecté à chaque cellule élémentaire, en tenant compte de la quantité de chaleur générée par la cellule en fonctionnement à la température Tref (déterminée à l'étape 402) et de la capacité de refroidissement de l'emplacement (déterminée à l'étape 403). Lors de cette étape, un procédé d'affectation simple du type susmentionné (affectation des emplacements disposant d'une bonne aptitude à évacuer la chaleur aux cellules générant une grande quantité de chaleur, et inversement) peut par exemple être utilisé.

Dans l'exemple de la figure 4, les étapes 401, 402, 403 et 404 définissent une phase d'initialisation du procédé.

Lors d'une étape 405 (modèle couplé électrique et thermique), on prévoit d'estimer, pour chaque cellule et pour l'affectation initiale effectuée lors des étapes 401, 402, 403 et 404 (en tenant compte notamment de la capacité de l'emplacement affecté à chaque cellule à évacuer la chaleur, et de la quantité d'énergie susceptible d'être dissipée par chaque cellule à la température Tref), la température effective de fonctionnement Ti de la cellule.

Lors d'une étape 406 (calcul Ecᵢ pour les températures Ti), on prévoit, pour chaque cellule, d'estimer la résistance interne effective de la cellule à sa température effective de fonctionnement Ti. A partir de cette résistance interne effective, on prévoit de calculer la quantité d'énergie Ecᵢ effectivement dissipée par effet Joule par chaque cellule en fonctionnement. Lors de l'étape 405, les températures de fonctionnement Ti des différentes cellules peuvent être différentes les unes des autres et différentes de la température de référence Tref. Les résistances internes des cellules déterminées à l'étape 406 peuvent donc être différentes de celles mesurées à l'étape 401. Pour estimer la résistance interne Rcᵢ(Tᵢ) d'une cellule à une température Ti autre que la température Tref utilisée lors de la mesure de résistance interne (étape 401), on peut utiliser une fonction permettant de calculer Rcᵢ(Tᵢ) en fonction de Rcᵢ(Tref), Tref et Ti, où Rcᵢ(Tref) est la résistance interne de la cellule mesurée à la température Tref.

Lors d'une étape 407 (calcul d'un critère de pertinence de l'affectation choisie), on prévoit de calculer un critère permettant de juger de la pertinence de l'affectation des emplacements aux cellules, par exemple l'écart de température maximal entre les différentes cellules de la batterie, la consommation électrique totale de la batterie, etc.

Lors d'une étape 408 (nouveau placement de cellules pour optimiser le critère de pertinence), on prévoit de définir une nouvelle affectation des emplacements aux cellules, en essayant d'améliorer - réduire ou augmenter - le critère de pertinence choisi.

Lors d'une étape de test 409 (critère cible atteint ?), on vérifie si le critère de pertinence choisi a atteint une valeur cible. Si oui (Y), le placement courant des cellules est retenu comme placement final pour la réalisation de la batterie lors d'une étape 411 (placement retenu). Si non (N), on vérifie, lors d'une étape de test 410 (nombre d'itérations max atteint ?), si un nombre maximum d'itérations de la partie itérative du procédé a été atteint. Si le nombre maximum d'itérations prévu a été atteint (Y), le placement courant des cellules est retenu comme placement final pour la réalisation de la batterie. Si le nombre maximum d'itérations n'a pas été atteint (N), on prévoit de réitérer les étapes 405 à 411 susmentionnées, et ainsi de suite jusqu'à atteindre la valeur cible du critère de pertinence ou le nombre maximum d'itérations autorisé. L'affectation la plus favorable par rapport au critère de pertinence choisi est alors retenue pour le placement final des cellules.

Lors d'étapes ultérieures, non représentées, les cellules élémentaires sont assemblées et connectées les unes aux autres pour réaliser la batterie.

Un avantage du mode de réalisation de la figure 2 et de la variante de réalisation de la figure 4 est qu'en plaçant les cellules dont la propension à produire de la chaleur est la plus importante, aux emplacements les plus aptes à évacuer la chaleur, on limite l'élévation de température de ces cellules, et par conséquent leur vieillissement. La durée de vie de la batterie s'en trouve prolongée et l'évolution de ses performances dans le temps améliorée.

La figure 3 est un schéma bloc illustrant des étapes d'un exemple d'un autre mode de réalisation d'un procédé de fabrication d'une batterie électrique.

Lors d'une étape 301 (mesure Rcᵢ), la résistance interne Rcᵢ de chacune des cellules élémentaires de la batterie est mesurée.

Lors d'une étape 302 (modèle thermique), par exemple identique à l'étape 203 du procédé de la figure 2, un modèle thermique de la batterie est déterminé, c'est-à-dire que les emplacements de cellule de la batterie sont classés en fonction de leur aptitude à évacuer la chaleur, ou capacité de refroidissement.

Lors d'une étape 303 (placement des cellules), un emplacement est affecté à chaque cellule élémentaire de la batterie, en tenant compte de la résistance interne Rcᵢ de la cellule et de la capacité de refroidissement de l'emplacement, de façon que les emplacements disposant d'une grande aptitude à évacuer la chaleur soient affectés à des cellules de forte résistivité, et inversement.

A titre d'exemple de procédé simple d'affectation des emplacements aux cellules, si un classement des cellules par ordre croissant de résistivité est réalisé à l'étape 301, et si un classement des emplacements par ordre croissant de capacité de refroidissement est réalisé à l'étape 302, le premier emplacement du classement d'emplacements est affecté à la première cellule du classement de cellules, le deuxième emplacement du classement d'emplacements est affecté à la deuxième cellule du classement de cellules, et ainsi de suite. Des procédés d'affectation plus perfectionnés, par exemple du type décrit en relation avec la figure 4, comprenant l'optimisation d'un critère de pertinence de l'affectation, peuvent toutefois être prévus.

Les cellules élémentaires sont ensuite fixées et connectées les unes aux autres pour réaliser la batterie.

Un avantage du mode de réalisation de la figure 3 est qu'il permet d'homogénéiser, au cours du temps, les résistances internes des différentes cellules, ce qui peut permettre de réduire l'effort d'équilibrage entre les différentes cellules de la batterie au cours de la durée de vie de la batterie. En effet, le vieillissement d'une cellule sous l'effet de la chaleur se traduit par une augmentation de la résistance interne de cette cellule. Ainsi, au cours d'une période de temps donnée, une cellule subissant un échauffement important verra sa résistance interne augmenter plus fortement qu'une cellule subissant un échauffement plus faible, et inversement. Le mode de réalisation de la figure 3 utilise donc la disparité d'aptitude des emplacements à évacuer la chaleur, pour que le vieillissement des cellules aille dans le sens d'une compensation de la dispersion de fabrication des cellules.

On notera que dans le cas d'une connexion en série des cellules, les modes de réalisation des figures 2 et 3 correspondent à un même agencement des cellules dans la batterie, c'est-à-dire que les emplacements les moins confinés sont affectés aux cellules les plus résistives, et inversement. Les avantages des deux modes de réalisation sont alors cumulés. En revanche, dans le cas d'un assemblage en parallèle des cellules, les modes de réalisation des figures 2 et 3 correspondent à des agencements différents : dans le mode de réalisation de la figure 2, les emplacements les moins confinés sont affectés aux cellules les moins résistives et inversement, et dans le mode de réalisation de la figure 3, les emplacements les moins confinés sont affectés aux cellules les plus résistives et inversement. On pourra privilégier un mode de réalisation plutôt que l'autre en fonction des conditions d'utilisation de la batterie. Par exemple, si la batterie est destinée à fonctionner dans un environnement bien refroidi dans lequel des seuils de température critique ne seront jamais atteints, même dans les cellules les plus confinées, le mode de réalisation de la figure 3 peut être privilégié.

Un avantage des modes de réalisation décrits en relation avec les figures 2 et 3 est qu'ils sont faciles à mettre en oeuvre et ne conduisent pas à une augmentation du poids de la batterie. Ceci présente un intérêt tout particulier dans le cas d'une utilisation de la batterie pour une application embarquée, par exemple dans un vélo électrique.

Par ailleurs, les modes de réalisation décrits trouvent un intérêt tout particulier pour des batteries utilisant des cellules au lithium ou des cellules nickel-hydrure métallique (NiMH), particulièrement sensibles à la chaleur.

En outre, les modes de réalisation décrits sont particulièrement avantageux pour des batteries de forte puissance telles que des batteries pour véhicule électrique ou des batteries de stockage reliées à un réseau électrique (par exemple des batteries de stockage pour la régulation de fréquence, par exemple dans des centrales solaires), dans lesquelles les élévations de température peuvent être particulièrement importantes.

On notera que dans les modes de réalisation décrits, les étapes comprises entre la mesure des résistances internes Rcᵢ des différentes cellules, et l'assemblage de la batterie proprement dit, peuvent être réalisées au moyen d'une unité de calcul tel qu'un ordinateur. A titre d'exemple, les valeurs des résistances internes des différentes cellules peuvent être communiquées à l'ordinateur qui, connaissant le modèle thermique de la batterie ou étant capable de le déterminer, et connaissant, le cas échéant, le schéma électrique de la batterie, affecte automatiquement à chaque cellule élémentaire un emplacement dans la batterie, par exemple selon un algorithme d'affectation simple du type susmentionné, ou selon un algorithme plus perfectionné du type décrit en relation avec la figure 4, comportant un procédé itératif d'optimisation d'un critère de qualification de l'affectation des emplacements aux cellules.

Des modes de réalisation particuliers de la présente invention ont été décrits. Diverses variantes et modifications apparaîtront à l'homme de l'art.

En particulier, il est connu qu'une batterie peut être divisée en plusieurs modules comprenant chacun une pluralité de cellules reliées en série ou en parallèle entre deux noeuds ou bornes de contact du module, les modules étant reliés en série ou en parallèle entre les bornes de la batterie. Bien que cela n'ait pas été mentionné ci-dessus, l'homme de l'art saura ajouter de la modularité aux modes de réalisation décrits ci-dessus.

De plus, l'invention ne se limite pas aux batteries utilisant des cellules au lithium ou des cellules NiMH. L'homme de l'art saura mettre en oeuvre les procédés décrits ci-dessus pour réaliser des batteries utilisant d'autres types de cellules élémentaires.

Par ailleurs, dans les exemples décrits ci-dessus, la batterie n'est pas équipée d'un système de refroidissement ou d'évacuation de chaleur complémentaire. Les modes de réalisation décrits ne se limitent toutefois pas à ce cas particulier. L'homme de l'art saura réaliser une batterie dans laquelle les cellules élémentaires sont positionnées en tenant compte de leurs résistances internes, cette batterie comportant en outre des moyens complémentaires de refroidissement ou d'évacuation de chaleur. Dans ce cas, un avantage des modes de réalisation proposés est que le système de refroidissement complémentaire peut être sous-dimensionné par rapport aux systèmes de refroidissements prévus dans les batteries existantes, ou, si il n'est pas sous-dimensionné, que la température des cellules au cours du fonctionnement de la batterie se trouve réduite par rapport aux batteries existantes, ce qui prolonge la durée de vie de la batterie.

Enfin, la mise en oeuvre pratique des modes de réalisation qui ont été décrits est à la portée de l'homme du métier à partir des indications fonctionnelles décrites ci-dessus.

## Revendications

1. Procédé de réalisation d'une batterie (14) comportant plusieurs cellules (cᵢ), comprenant les étapes suivantes :
définir des emplacements d'accueil des cellules (cᵢ) ;
mesurer la résistance interne (Rcᵢ) de chaque cellule (cᵢ) ;
déterminer, pour chaque emplacement, un paramètre représentatif de l'aptitude de l'emplacement à évacuer la chaleur ; et
affecter un emplacement dans la batterie à chaque cellule (cᵢ) en tenant compte des résistances internes (Rcᵢ) respectives des cellules et des aptitudes respectives des emplacements à évacuer la chaleur,
dans lequel les emplacements présentant les aptitudes à évacuer la chaleur les plus élevées sont affectés aux cellules (cᵢ) les plus résistives, et inversement, ou dans lequel les emplacements présentant les aptitudes à évacuer la chaleur les plus élevées sont affectés aux cellules (cᵢ) dissipant la plus grande quantité d'énergie (Ecᵢ) par effet Joule, et inversement.

2. Procédé selon la revendication 1, dans lequel les cellules sont identiques à la dispersion de fabrication près.

3. Procédé selon la revendication 1 ou 2, dans lequel l'affectation des emplacements aux cellules (cᵢ) comprend la séquence d'étapes suivantes :
classer les emplacements par ordre d'aptitude à évacuer la chaleur ;
classer les cellules (cᵢ) par ordre de quantité de chaleur dissipée par effet Joule à une température de référence ; et
affecter les emplacements présentant les aptitudes à évacuer la chaleur les plus élevées aux cellules (cᵢ) dissipant la plus grande quantité d'énergie (Ecᵢ) à ladite température de référence, et inversement.

4. Procédé selon la revendication 1 ou 2, dans lequel l'affectation des emplacements aux cellules (cᵢ) comprend une affectation initiale des emplacements aux cellules pouvant par exemple être réalisée selon le procédé de la revendication 3, puis comprend en outre une ou plusieurs itérations de la séquence d'étapes suivante :
a) calculer, pour chaque cellule (cᵢ), la quantité d'énergie dissipée par effet Joule par la cellule en fonctionnement, en tenant compte de la capacité à évacuer la chaleur de l'emplacement affecté à la cellule lors d'une séquence précédente ;
b) calculer un critère caractéristique de la pertinence de l'affectation des emplacements aux cellules (cⱼ) ; et
c) définir une nouvelle affectation des emplacements aux cellules.

5. Procédé selon la revendication 4, dans lequel plusieurs itérations de ladite séquence sont mises en oeuvre, et dans lequel, à l'issue desdites itérations, l'affectation la plus favorable par rapport audit critère est retenue.

6. Procédé selon la revendication 4 ou 5, dans lequel ledit critère est l'écart maximal de température entre les différentes cellules de la batterie en fonctionnement.

7. Procédé selon la revendication 4 ou 5, dans lequel ledit critère est la consommation électrique totale de la batterie.

8. Procédé selon l'une quelconque des revendications 1 à 7, dans lequel ledit agencement tient compte du schéma de connexion électrique des cellules (cᵢ) de la batterie (14).

9. Procédé selon l'une quelconque des revendications 1 à 8, dans lequel l'affectation des emplacements aux cellules (cᵢ) est déterminée à l'aide d'une unité de calcul.

## Patentansprüche

1. Ein Verfahren zum Bilden eines Akkus bzw. einer Batterie (14), der bzw. die eine Vielzahl von Zellen (cᵢ) aufweist, das die folgenden Schritte aufweist:
Definieren von Positionen zum Aufnehmen der Zellen (cᵢ);
Messen des Innenwiderstandes (Rcᵢ) jeder Zelle (cᵢ);
Bestimmen, für jede Position, eines Parameters, der für die Wärmeabführungsfähigkeit der Position repräsentativ ist; und
Zuweisen einer Position in der Batterie bzw. dem Akku zu jeder Zelle (cᵢ), wobei jeweilige Innenwiderstände (Rcᵢ) der Zellen und die jeweiligen Wärmeabführungsfähigkeiten der Positionen berücksichtigt werden,
wobei die Positionen, die die höchsten Wärmeabführungsfähigkeiten haben, den Zellen (cᵢ) mit dem größten Widerstand zugewiesen werden und umgekehrt, oder wobei die Positionen mit den höchsten Wärmeabführungsfähigkeiten den Zellen (cᵢ) zugewiesen werden, die die größte Menge an Energie (Ecᵢ) gemäß dem Joule-Effekt abgeben, und umgekehrt.

2. Verfahren nach Anspruch 1, wobei die Zellen identisch sind, abgesehen von einer Herstellungsstreuung.

3. Verfahren nach Anspruch 1 oder 2, wobei die Zuweisung der Positionen zu den Zellen (cᵢ) die folgende Schrittsequenz aufweist:
Klassifizieren der Positionen in der Reihenfolge ihrer Wärmeabführungsfähigkeit;
Klassifizieren der Zellen (cⱼ) in der Reihenfolge der Menge an Wärme, die gemäß dem Joule-Effekt bei einer Referenztemperatur abgegeben wird; und
Zuweisen der Positionen mit den höchsten Wärmeabführungsfähigkeiten zu den Zellen (cⱼ), die die größte Menge an Energie (Ecᵢ) bei der Referenztemperatur abgeben, und umgekehrt.

4. Verfahren nach Anspruch 1 oder 2, wobei die Zuweisung der Positionen zu den Zellen (cⱼ) einen anfängliche Zuweisung der Positionen zu den Zellen aufweist, die beispielsweise gemäß dem Verfahren nach Anspruch 3 durchgeführt werden kann, und dann weiter eine oder eine Vielzahl von Iterationen der folgenden Schrittsequenz aufweist:
a) Berechnen, für jede Zelle (cⱼ), der Menge an Energie, die gemäß dem Joule-Effekt durch die Zelle im Betrieb abgegeben wird, wobei die Wärmeabführungsfähigkeit der Position, die der Zelle während einer vorhergehenden Sequenz zugewiesen wurde, berücksichtigt wird;
b) Berechnen eines Kriteriums, das für die Relevanz der Zuweisung der Positionen zu den Zellen (cⱼ) charakteristisch ist; und
c) Definieren einer neuen Zuweisung der Positionen zu den Zellen.

5. Verfahren nach Anspruch 4, wobei eine Vielzahl von Iterationen der Sequenz implementiert wird, und wobei, am Ende der Iterationen, die am meisten vorteilhafte Zuweisung relativ zu dem Kriterium beibehalten wird.

6. Verfahren nach Anspruch 4 oder 5, wobei das Kriterium die maximale Temperaturdifferenz zwischen den unterschiedlichen Zellen der Batterie bzw. des Akkus im Betrieb ist.

7. Verfahren nach Anspruch 4 oder 5, wobei das Kriterium der gesamte elektrische Leistungsverbrauch der Batterie bzw. des Akkus ist.

8. Verfahren nach einem der Ansprüche 1 bis 7, wobei das Layout bzw. die Anordnung den Schaltplan der elektrischen Verbindung der Zellen (cᵢ) der Batterie bzw. des Akkus (14) berücksichtigt.

9. Verfahren nach einem der Ansprüche 1 bis 8, wobei die Zuweisung der Positionen zu den Zellen (cⱼ) durch Mittel einer Berechnungseinheit bestimmt wird.

## Claims

1. A method of forming a battery (14) comprising a plurality of cells (cᵢ), comprising the steps of:
defining locations for receiving the cells (cᵢ);
measuring the internal resistance (Rcᵢ) of each cell (cᵢ) ;
determining, for each location, a parameter representative of the heat removal ability of the location; and
assigning a location in the battery to each cell (cᵢ), taking into account respective internal resistances (Rcᵢ) of the cells and the respective heat removal abilities of the locations,
wherein the locations having the highest heat removal abilities are assigned to the most resistive cells (cᵢ), and conversely, or wherein the locations having the highest heat removal abilities are assigned to the cells (cᵢ) dissipating the largest quantity of energy (Ecᵢ) by Joule effect, and conversely.

2. The method of claim 1, wherein the cells are identical except for manufacturing dispersion.

3. The method of claim 1 or 2, wherein the assignment of the locations to the cells (cᵢ) comprises the following step sequence:
classifying the locations by order of heat removal ability;
classifying the cells (cⱼ) by order of quantity of heat dissipated by Joule effect at a reference temperature; and
assigning the locations having the highest heat removal abilities to the cells (cⱼ) dissipating the largest quantity of energy (Ecᵢ) at said reference temperature, and conversely.

4. The method of claim 1 or 2, wherein the assignment of the locations to the cells (cⱼ) comprises an initial assignment of the locations to the cells which may for example be performed according to the method of claim 3, and then further comprises one or a plurality of iterations of the following step sequence:
a) calculating, for each cell (cⱼ), the quantity of energy dissipated by Joule effect by the cell in operation, taking into account the heat removal capacity of the location assigned to the cell during a previous sequence;
b) calculating a criterion characteristic of the relevance of the assignment of the locations to the cells (cⱼ); and
c) defining a new assignment of the locations to the cells.

5. The method of claim 4, wherein a plurality of iterations of said sequence are implemented, and wherein, at the end of said iterations, the most favorable assignment relative to said criterion is retained.

6. The method of claim 4 or 5, wherein said criterion is the maximum temperature difference between the different cells of the battery in operation.

7. The method of claim 4 or 5, wherein said criterion is the total electric power consumption of the battery.

8. The method of any of claims 1 to 7, wherein said layout takes into account the diagram of electric connection of the cells (cᵢ) of the battery (14).

9. The method of any of claims 1 to 8, wherein the assignment of the locations to the cells (cⱼ) is determined by means of a calculation unit.
